# DEMANDE DE BREVET EUROPEEN

(11) **EP 4 651 668 A1**
(43) Date de publication de la demande: **19.11.2025**
(21) Numéro de dépôt: 25173722.7
(22) Date de dépôt: 30.04.2025
(51) Int. Cl.: H10B 63/00, H10B 63/10, H10D 84/90, H10N 70/00, H10N 70/20

(54) **PROCEDE DE FABRICATION D'UN DISPOSITIF ELECTRONIQUE COMPRENANT UN CIRCUIT MEMOIRE**

(30) Priorité: 14.05.2024 FR 2404887
(71) Demandeur: STMicroelectronics International N.V., 1228 Plan-les-Ouates, Geneva (CH)
(72) Inventeur: WEBER, Olivier, 38000 Grenoble (FR); ARNAUD, Franck, 38330 Saint Nazaire Les Eymes (FR)
(74) Mandataire: Cabinet Beaumont

(57) **Abrégé**

La présente description concerne un dispositif électronique comportant :
- un substrat semiconducteur (13) ;
- une couche isolante (18), sur et en contact avec le substrat semiconducteur ; et
- un circuit mémoire comportant une pluralité de cellules mémoire, comprenant chacune un transistor bipolaire de sélection disposé dans et sur le substrat semiconducteur, chaque transistor bipolaire de sélection comportant, une région de base (29, 15), une région d'émetteur (27) et une région de collecteur (17),
dans lequel chaque transistor bipolaire de sélection comprend une structure d'isolation (16) en un premier matériau diélectrique, la structure d'isolation comportant une partie supérieure s'étendant verticalement dans la couche isolante et une partie inférieure s'étendant verticalement dans le substrat semiconducteur entre la région de base et la région d'émetteur, les faces latérales de la partie supérieure de la structure **d'isolation** étant recouvertes par des espaceurs (21) en un deuxième matériau diélectrique.

## Description

### Domaine technique

La présente description concerne de façon générale les dispositifs électroniques et plus particulièrement les dispositifs électroniques comprenant un circuit mémoire.

### Technique antérieure

Des dispositifs électroniques comportent à la fois des circuits mémoires et des circuits logiques. On s'intéresse ici plus particulièrement à des dispositifs électroniques comprenant des circuits mémoires incluant des éléments mémoires disposés en matrice, chaque élément mémoire étant associé à un transistor bipolaire de sélection. Ce transistor est utilisé pour programmer, effacer ou lire chaque élément mémoire indépendamment.

Il serait souhaitable d'améliorer au moins en partie certains aspects des dispositifs électroniques connus.

### Résumé de l'invention

Pour cela, un mode de réalisation prévoit un dispositif électronique comportant :
- un substrat semiconducteur ;
- une couche isolante recouvrant le substrat semiconducteur, sur et en contact avec le substrat semiconducteur ; et
- un circuit mémoire comportant une pluralité de cellules mémoire, comprenant chacune un transistor bipolaire de sélection disposé dans et sur le substrat semiconducteur, chaque transistor bipolaire de sélection comportant, une région de base, une région d'émetteur et une région de collecteur,
dans lequel chaque transistor bipolaire de sélection comprend une structure d'isolation en un premier matériau diélectrique, la structure d'isolation comportant une partie supérieure s'étendant verticalement dans la couche isolante et une partie inférieure s'étendant verticalement dans le substrat semiconducteur entre la région de base et la région d'émetteur, les faces latérales de la partie supérieure de la structure d'isolation étant recouvertes par des espaceurs en un deuxième matériau diélectrique.

Selon un mode de réalisation, le dispositif comporte en outre un circuit logique comportant une pluralité de transistors à effet de champ à ailettes disposé dans et sur le substrat semiconducteur, chaque transistor à effet de champ à ailettes comportant, une région de source et une région de drain,
dans lequel deux transistors à effet de champ à ailettes voisins sont séparés par une autre structure d'isolation en le premier matériau diélectrique, la structure d'isolation comportant une partie supérieure s'étendant verticalement dans la couche isolante et une partie inférieure s'étendant verticalement dans le substrat semiconducteur entre la région de drain et la région de source des deux transistors voisins, les faces latérales de la partie supérieure de la structure d'isolation étant recouvertes par des espaceurs en le deuxième matériau diélectrique.

Selon un mode de réalisation, les structures d'isolation du circuit mémoire et les structures d'isolation du circuit logique ont la même profondeur.

Selon un mode de réalisation, les structures d'isolation du circuit mémoire et les structures d'isolation du circuit logique ont des profondeurs différentes.

Selon un mode de réalisation, chaque cellule mémoire comprend un élément mémoire comportant une couche en un matériau à changement de phase.

Selon un mode de réalisation, le circuit mémoire comporte un empilement d'interconnexion disposé sur le substrat semiconducteur, comportant une succession de niveaux dans lequel sont définis des éléments d'interconnexion.

Selon un mode de réalisation, les éléments mémoires sont disposés au dessus de l'empilement d'interconnexion.

Un autre mode de réalisation prévoit un procédé de fabrication, dans et sur un substrat semiconducteur, d'un dispositif électronique comportant un circuit mémoire comprenant une pluralité de cellules mémoires comprenant chacune un transistor bipolaire de sélection formé dans et sur le substrat semiconducteur, chaque transistor bipolaire de sélection comportant, une région de base, une région d'émetteur et une région de collecteur, le procédé comportant les étapes de :
- formation de grilles sacrificielles en un matériau sacrificiel sur le substrat semiconducteur ;
- formation d'espaceurs en un matériau diélectrique sur les faces latérales des grilles sacrificielles ;
- retrait du matériau sacrificiel dans les grilles sacrificielles et gravure du substrat en vis-à-vis des grilles sacrificielles de façon à former des ouvertures entourées dans une partie supérieure par les espaceurs et s'étendant dans une partie inférieure dans le substrat et remplissage des ouvertures avec un autre matériau diélectrique de manière à former des structures d'isolation en l'autre matériau diélectrique ; et
- formation d'une couche isolante sur et en contact avec le substrat semiconducteur, les structures d'isolation comportant ainsi une partie supérieure s'étendant verticalement dans la couche isolante et une partie inférieure s'étendant verticalement dans le substrat semiconducteur entre la région de base et la région d'émetteur des transistors bipolaires, les faces latérales de la partie supérieure de chaque structure d'isolation étant recouvertes par les espaceurs.

Selon un mode de réalisation, le dispositif comporte en outre un circuit logique, le circuit logique comportant une pluralité de transistors à effet de champs à ailettes comportant chacun une région de source et une région de drain, le procédé comportant les étapes de :
- formation des grilles sacrificielles en un matériau sacrificiel sur le substrat semiconducteur ;
- formation d'espaceurs en le matériau diélectrique sur les faces latérales des grilles sacrificielles ;
- retrait du matériau sacrificiel dans les grilles sacrificielles et gravure du substrat en vis-à-vis des grilles sacrificielles de façon à former des ouvertures entourées dans une partie supérieure par les espaceurs et s'étendant dans une partie inférieure dans le substrat et remplissage des ouvertures avec l'autre matériau diélectrique de manière à former des autres structures d'isolation en l'autre matériau diélectrique ; et
- formation de la couche isolante sur et en contact avec le substrat semiconducteur, les autres structures d'isolation comportant ainsi une partie supérieure s'étendant verticalement dans la couche isolante et une partie inférieure s'étendant verticalement dans le substrat semiconducteur entre la région de source et la région de drain de chaque transistor à effet de champs à ailettes, les faces latérales de la partie supérieure de l'autre structure d'isolation étant recouvertes par les espaceurs.

Selon un mode de réalisation, les étapes de formation des structures d'isolation du circuit mémoire et les autres structures d'isolation du circuit logique sont communes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C sont des vues, partielles et schématiques, d'un exemple d'un dispositif électronique selon un premier mode de réalisation ;
la figure 2, la figure 3, la figure 4, la figure 5, la figure 6, la figure 7A, la figure 7B, la figure 7C, la figure 7D, la figure 8A, la figure 8B, la figure 9A, la figure 9B, la figure 10A, la figure 10B, la figure 11A, la figure 11B, la figure 12A, la figure 12B, la figure 13A, la figure 13B, la figure 14A, la figure 14B, la figure 15A, la figure 15B, la figure 16A et la figure 16B sont des vues illustrant des étapes d'un exemple de procédé de fabrication de la puce électronique illustrée en figures 1A, 1B et 1C ;
la figure 17A et la figure 17B sont des vues, partielles et schématiques, d'un exemple d'un dispositif électronique selon un deuxième mode de réalisation ; et
la figure 18A et la figure 18B sont des vues, partielles et schématiques, d'un exemple d'un dispositif électronique selon un troisième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

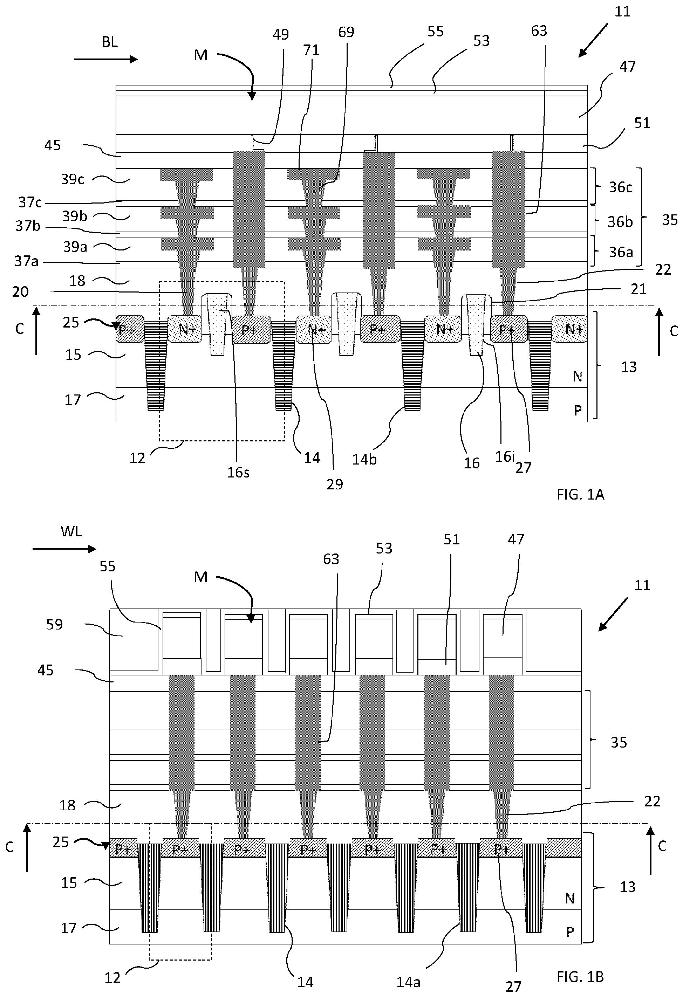

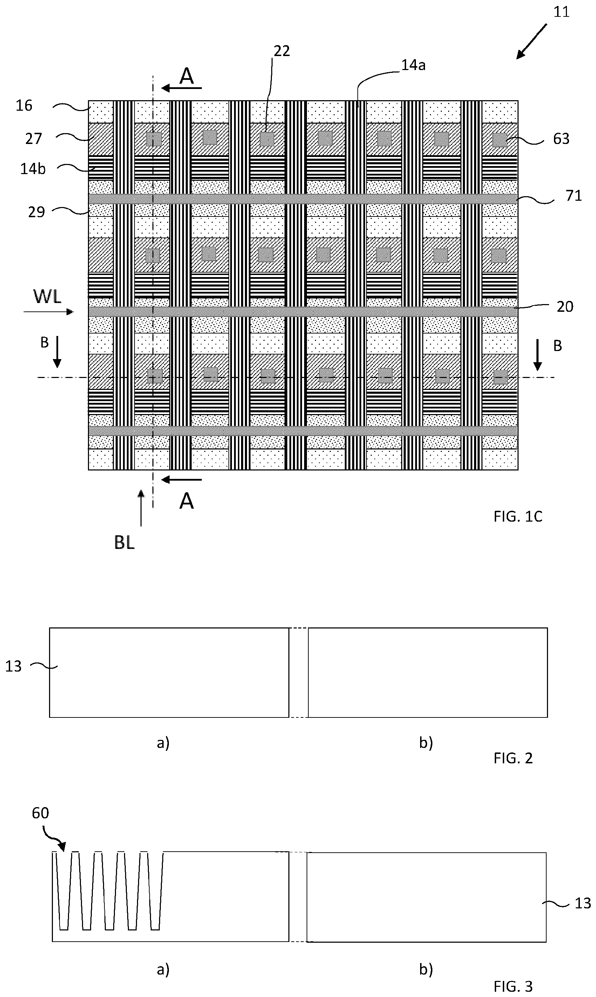

La figure 1A, la figure 1B et la figure 1C sont des vues en coupe, partielles et schématiques, d'un exemple d'un dispositif électronique selon un premier mode de réalisation. Plus précisément, les figures 1A et 1B sont des vues en coupe verticales dudit dispositif et la figure 1C est une vue en coupe horizontale dudit dispositif, la figure 1A correspondant à une vue selon le plan de coupe AA de la figure 1C, la figure 1B correspondant à une vue selon le plan de coupe BB de la figure 1C et la figure 1C correspondant à une vue de dessus selon le plan de coupe horizontal CC des figures 1A et 1B. Notons qu'en figure 1C, certains des éléments ont été représentés en transparence.

Plus particulièrement, la figure 1A, la figure 1B et la figure 1C illustrent un circuit mémoire du dispositif électronique 11. A titre d'exemple, le dispositif électronique 11 comprend, dans une portion non représentée, un circuit logique. Les circuits logique et mémoire sont, par exemple, fabriqués simultanément dans et sur un même substrat semiconducteur.

Le dispositif 11 est par exemple une puce électronique.

Le dispositif 11 comprend un substrat semiconducteur 13. A titre d'exemple, le substrat 13 est en silicium ou à base de silicium.

Le substrat 13 comprend, par exemple, une couche semiconductrice 15 dopée d'un premier type de conductivité, par exemple du type N, par exemple dopée d'atomes d'arsenic ou de phosphore. La couche 15 repose par exemple sur, et est par exemple en contact avec, une autre couche semiconductrice 17 du substrat 13 dopée d'un deuxième type de conductivité, opposé au premier type de conductivité, par exemple du type P, par exemple dopée d'atomes de bore.

Le substrat 13 comprend par exemple une couche semiconductrice 25. La couche 25 repose par exemple sur la couche 15, et est par exemple en contact avec celle ci. Ainsi, la couche 25 est séparée de la couche 17 par la couche 15. La couche 25 affleure par exemple une face supérieure du substrat 13. La couche semiconductrice 25 est par exemple une couche formée par épitaxie à partir de la face supérieure de la couche 15. La couche 25 est, par exemple en silicium, par exemple en silicium monocristallin. La couche 25 comprend, par exemple, une pluralité de régions 27 et de régions 29. Dans le mode de réalisation des figures 1A à 1C, les régions 27 s'étendent longitudinalement sous forme de lignes dans une première direction et les régions 29 s'étendant longitudinalement sous forme de lignes dans la même première direction. A titre d'exemple, les régions 27 et 29 s'étendent dans la direction du plan de la figure 1B. Le substrat 13 comprend ainsi, dans l'exemple des figures 1A à 1C, des lignes comprenant une alternance de régions 27 et 29 s'étendant dans la première direction.

Chaque région 27 ou 29 s'étend de préférence sur toute la hauteur de la couche 25. Chaque région 27 ou 29 affleure ainsi la face supérieure de la couche 25. Chaque région 27 ou 29 est par exemple en contact, par sa face inférieure, avec la couche 15.

Les régions 27 sont par exemple dopées du deuxième type de conductivité, par exemple du type P. A titre d'exemple, les régions 27 comportent des atomes de germanium et de bore. Les régions 27 sont, par exemple plus fortement dopées que la couche 17.

Les régions 29 sont par exemple dopées du premier type de conductivité, par exemple du type N. A titre d'exemple, les régions 29 comportent des atomes de phosphore. Les régions 29 sont, par exemple, plus fortement dopées que la couche 15.

Le dispositif 11 comprend une pluralité de transistors 12 formés dans et sur le substrat 13. Chaque transistor 12 comprend, par exemple, une unique région 27 et une unique région 29 du substrat 13.

Les transistors 12 sont par exemple séparés les uns des autres et sont par exemple isolées électriquement par des tranchées isolantes 14, ou tranchées d'isolation 14. Les tranchées isolantes 14 sont par exemple des tranchées d'isolation peu profondes (STI, de l'anglais " Shallow Trench Isolation"). Les tranchées 14 sont par exemple divisées en deux catégories : les tranchées 14a s'étendant longitudinalement dans la première direction et les tranchées 14b s'étendant longitudinalement dans la deuxième direction. A titre d'exemple, les tranchées d'isolation 14a et 14b forment, en vue de dessus, une grille.

Les tranchées d'isolation 14 s'étendent, par exemple, à partir d'une face située à un niveau intermédiaire compris entre la face supérieure et la face inférieure de la couche 25. Les tranchées 14 s'étendent de préférence dans une partie de la couche 25, dans la couche 15 et dans une partie de la couche 17. Les tranchées d'isolation 14 sont par exemple remplies d'un matériau diélectrique, par exemple de l'oxyde de silicium. Les tranchées 14a et 14b ont, par exemple, la même profondeur. La profondeur des tranchées 14 est par exemple comprise entre 250 nm et 400 nm.

Les transistors 12 sont ainsi agencés en matrice à l'intérieur de la grille formée par les tranchées 14. Le substrat 13 comprend ainsi des lignes et des colonnes de transistors 12.

Chaque transistor 12 est compris dans une cellule mémoire élémentaire. Chaque cellule mémoire comporte en outre un élément mémoire M, formé de préférence au moins partiellement en regard dudit transistor 12, par exemple en regard de la région 27 dudit transistor 12. Les régions 29, à la différence des régions 27, ne sont par exemple pas surmontées d'éléments mémoires M. A titre d'exemple, au sein de chaque cellule mémoire, le transistor 12 est un transistor de sélection de l'élément mémoire M.

Les éléments mémoires M sont par exemple organisés, en vue de dessus, selon une matrice de lignes et de colonnes. On parle respectivement de lignes de mots (word lines) s'étendant dans la deuxième direction, c'est-à-dire la direction des tranchées 14b et de lignes de bits (bit lines), s'étendant dans la première direction, c'est à dire la direction des tranchées 14a. A titre d'exemple, chaque élément mémoire M est situé à l'intersection d'une ligne de bits et d'une ligne de mots. A titre d'exemple, les éléments mémoires M illustrés en figure 1B sont des éléments mémoires M d'une même ligne de mots WL alors que les éléments mémoires illustrés en figure 1A sont des éléments mémoires d'une même ligne de bits BL. En figure 1B, seulement six lignes de bits sont représentées et en figure 1A seulement trois lignes de mots sont représentées. Toutefois, en pratique, un circuit mémoire peut comprendre un nombre de lignes de bits et de lignes de mots différent, par exemple supérieur respectivement à six et trois.

A titre d'exemple, chaque tranchée d'isolation 14b s'étend longitudinalement dans la direction des lignes de mots, sur toute la longueur des lignes de mots. A titre d'exemple, chaque tranchée d'isolation 14a s'étend longitudinalement dans la direction des lignes de bits, sur toute la longueur des lignes de bits. La matrice des transistors 12 correspond sensiblement à la matrice des éléments mémoire M.

Dans l'exemple des figures 1A à 1C, chaque transistor 12 est défini par la couche 17, les régions 27 et les régions 29 reliées à la couche 15. Dans cet exemple, la région 27 constitue une région d'émetteur du transistor 12, la couche 15 constitue une région de base du transistor 12, la région 29 constitue une région d'accès à la base du transistor 12 et la couche 17 constitue une région de collecteur du transistor 12. A titre d'exemple, le collecteur est commun à tous les transistors 12 de la matrice et est, par exemple, connecté à la masse. Dans cet exemple, la région de base 15 est commune à tous les transistors 12 d'une même ligne de mots du circuit mémoire.

Les transistors 12 sont par exemple des transistors bipolaires de sélection (BJT, de l'anglais "Bipolar Junction Transistor"), de type PNP.

Le dispositif 11 comprend une couche isolante 18 recouvrant la face supérieure du substrat semiconducteur 13 et plus précisément la face supérieure de la couche 25. La couche isolante 18 est par exemple en contact avec la face supérieure de la couche 25. La couche isolante 18 recouvre par exemple l'ensemble de la face supérieure de la couche 25. La couche isolante 18 a par exemple une épaisseur comprise entre 80 nm et 300 nm, par exemple comprise entre 120 nm et 200 nm.

Le dispositif 11 comprend en outre des structures ou tranchées d'isolation 16. Les tranchées 16 sont par exemple des tranchées de rupture de diffusion unique (SDB, de l'anglais "Single Diffusion Break"). Les tranchées 16 s'étendent par exemple dans la couche 25 en séparant la région 27 et la région 29 de chaque transistor 12. En d'autres termes, les régions 27 et 29 de chaque transistor 12 sont séparées par une tranchée 16. A titre d'exemple, chaque tranchée 16 s'étend longitudinalement dans la direction des lignes de mots, par exemple sur toute la longueur des lignes de mots.

Chaque tranchée 16 est par exemple située entre deux tranchées 14b. Ainsi, le substrat 13 comprend, dans la direction des lignes de bits, une alternance de tranchées 14b et de tranchées 16.

Chaque tranchée d'isolation 16 comporte une partie supérieure 16s s'étendant verticalement dans la couche isolante 18 et une partie inférieure 16i s'étendant verticalement dans le substrat semiconducteur 13.

Les faces latérales de la partie supérieure 16s de chaque tranchée d'isolation 16 sont recouvertes par des espaceurs 21 en un deuxième matériau diélectrique. Les espaceurs 21 sont par exemple en un matériau électriquement isolant, par exemple en nitrure de silicium. A titre d'exemple, la partie supérieure 16s de chaque tranchée 16 comprend une portion inférieure pour laquelle les flancs de l'espaceur 21 qui l'entoure sont en contact avec la couche 25 et plus précisément avec les régions 27 et 29. A titre d'exemple, la face inférieure de chaque espaceur 21 repose sur la face supérieure de la couche 15, par exemple entre les régions 27 et 29.

La partie inférieure 16i des tranchées 16 s'étend dans la couche 15 à partir de la face supérieure de la couche 15. A titre d'exemple, la partie inférieure 16i des tranchées 16 ne s'étend pas jusqu'à la couche 17.

Les faces latérales de la partie inférieure 16i de chaque tranchée d'isolation 16 ne sont pas recouvertes par des espaceurs et la tranchée d'isolation 16 est, dans cette partie, directement en contact avec la couche 15 du substrat 13.

A titre d'exemple, les tranchées 16 s'étendent moins profondément que les tranchées 14. Les tranchées 16 s'étendent par exemple à partir d'une face située à un niveau intermédiaire compris entre la face supérieure et la face inférieure de la couche 18. Les tranchées d'isolation 16 sont par exemple remplies d'un matériau diélectrique, par exemple de l'oxyde de silicium. Les tranchées 16 ont par exemple une hauteur ou profondeur (mesurée entre la face supérieure et la face inférieure des tranchées 16) comprise entre 50 nm et 150 nm.

La couche 18 est par exemple traversée par des vias 20 et 22. Les vias 20 et 22 sont par exemple en contact, par leurs faces inférieures, avec la face supérieure de la couche 25 de sorte que chaque région 27 et 29 soit surmontée par un via 20 ou 22. A titre d'exemple, les vias 20 sont en contact avec les régions 27. A titre d'exemple, les vias 22 sont en contact avec les régions 29. Les vias 20 et 22 s'étendent par exemple sur toute la hauteur de la couche 18. Les vias 20 et 22 s'étendent ainsi de la face supérieure de la couche 18 à la face inférieure de la couche 18.

La couche 18 est par exemple surmontée d'un empilement d'interconnexion 35. Dans cet exemple, l'empilement d'interconnexion 35 est formé entre le substrat 13 et les éléments mémoires M. L'empilement d'interconnexion 35 est par exemple formé sur la face supérieure de la couche isolante 18 et recouvre par exemple toute la surface de la couche isolante 18.

L'empilement d'interconnexion 35 est par exemple formé d'une succession de niveaux 36, chaque niveau 36 comportant une couche isolante 37 et une couche isolante 39. L'empilement d'interconnexion 35 comprend par exemple un niveau 36a, comprenant une couche isolante 39a formée sur et en contact avec la face supérieure de la couche isolante 18. L'empilement d'interconnexion 35 comprend en outre dans le niveau 36a, une couche isolante 37a formée sur la couche isolante 39a. La couche isolante 37a est par exemple formée sur toute la surface de la couche isolante 39a. A titre d'exemple, la couche isolante 37a est en contact, par sa face inférieure, avec la face supérieure de la couche isolante 39a.

L'empilement d'interconnexion 35 peut en outre comprendre des niveaux supplémentaires formés sur le niveau 36a, c'est-à-dire sur et en contact avec la couche isolante 37a. En figures 1A et 1B, l'empilement d'interconnexion 35 comprend deux niveaux supplémentaires 36b et 36c par exemple formés respectivement des couches 37b et 39b et des couches 37c et 39c. En pratique, le nombre de niveaux dans l'empilement d'interconnexion 35 peut être différent de trois, par exemple supérieur à trois.

A titre d'exemple, l'empilement d'interconnexion 35 a une épaisseur comprise entre 200 nm et 800 nm, par exemple comprise entre 250 nm et 600 nm, par exemple de l'ordre de 350 nm.

A titre d'exemple, les couches isolantes 18 et 37 sont en un matériau de faible constante diélectrique, par exemple en un matériau ayant une constante diélectrique (correspondant à la permittivité dudit matériau par rapport à la permittivité du vide), inférieure à 5, par exemple inférieure à 4. Les couches isolantes 37 sont par exemple en SiCN. A titre d'exemple, les couches isolantes 39 sont en oxyde de faible permittivité, dits "low k" ou "ultra low k".

Chaque niveau 36 comprend des vias 69 conducteurs et des pistes conductrices 71, les pistes 71 s'étendant dans la couche 39 par exemple à partir la face supérieure de la couche 39, affleurant ainsi la face supérieure de la couche 39. De préférence, les pistes 71 d'un niveau 36 s'étendent exclusivement dans la couche 39 dudit niveau 36. Les vias 69 d'un niveau de l'empilement 35 s'étendent à travers la couche 39 et à travers la couche 37 de ce même niveau 36. Plus précisément, les vias 69 d'un niveau de l'empilement 35 s'étendent de la face inférieure d'une piste 71 du même niveau à la face inférieure de la couche 37 ou à la face supérieure d'un via 20 ou 22 traversant la couche 18.

Les vias et pistes conductrices 71 et 69 sont par exemple en un matériau métallique, par exemple en cuivre. A titre d'exemple, les pistes conductrices 71 s'étendent latéralement sur une surface comprise entre 20 nm par 20 nm et 60 nm par 60 nm, par exemple de l'ordre de 30 nm par 30 nm. A titre d'exemple, les pistes conductrices 71 s'étendent latéralement sur une surface supérieure ou égale à la surface des vias 69.

Les éléments mémoires M sont, dans le mode de réalisation des figures 1A à 1C, formés sur la face supérieure de l'empilement 35. A titre d'exemple, les éléments mémoires M sont séparés de l'empilement 35 par une couche isolante 45. La couche isolante 45 est par exemple en nitrure de silicium, en SiCN, en un oxyde ou en un empilement de plusieurs de ces matériaux, par exemple en un empilement de SiCN et d'un oxyde. La couche 45 est par exemple en contact, par sa face inférieure, avec la face supérieure de la couche 39c. La couche 45 est en outre en contact, par sa face supérieure, avec la face inférieure des éléments mémoires M.

A titre d'exemple, les éléments mémoires M sont des éléments mémoires à changement de phase. A titre d'exemple, chaque élément comprend une couche 47 en un matériau à changement de phase, par exemple un matériau chalcogènure, par exemple un alliage de germanium, antimoine et tellure (GeSbTe) dit GST. La couche 47 a, par exemple, une épaisseur comprise entre 30 nm et 100 nm, par exemple, de l'ordre de 50 nm. Les éléments mémoires M d'une même ligne de bits comprennent par exemple une couche 47 commune. Ainsi, le dispositif 11 comprend par exemple autant de couche 47 que de lignes de bits. Chaque couche 47 s'étend ainsi dans la direction des lignes de bits.

Dans chaque élément mémoire M, le matériau à changement de phase est, par exemple, contrôlé par un élément résistif métallique chauffant 49 situé sous le matériau à changement de phase. L'élément 49 est par exemple en contact, par sa face supérieure, avec la face inférieure de la couche 47. L'élément 49 est par exemple entouré latéralement d'une couche en un isolant thermique 51. Par exemple, chaque élément 49 a une forme de "L" dans le plan de coupe de la figure 1A. A titre d'exemple, la couche 51 est en nitrure. A titre d'exemple, l'élément chauffant 49 a, par exemple, une hauteur comprise entre 30 nm et 100 nm, par exemple de l'ordre de 60 nm.

La couche 47 est, par exemple surmontée par une couche 53, par exemple en un matériau conducteur, par exemple en un matériau métallique. Plus précisément, la face supérieure de chaque couche 47 est par exemple au moins partiellement recouverte, par exemple entièrement recouverte, par une couche 53. Chaque couche 53 s'étend de préférence, dans la direction des lignes de bits, sur toute la longueur de la couche 47.

A titre d'exemple, dans chaque élément mémoire M, l'élément métallique 49 et la couche 53 forment respectivement une électrode inférieure et une électrode supérieure de l'élément mémoire M, et plus précisément des électrodes de l'élément résistif à résistance variable formé par la couche 47 en le matériau à changement de phase. A titre d'exemple, les éléments mémoires M d'une même ligne de bits sont surmontés d'une même couche 53. En d'autres termes, les électrodes supérieures 53 des éléments mémoires M d'une même ligne de bits sont interconnectées.

Chaque élément mémoire M est par exemple recouvert par une couche d'isolation 55 protégeant, par exemple la couche 47 en le matériau à changement de phase de l'oxydation. A titre d'exemple, la couche 55 recouvre la face supérieure de la couche 53 et les flancs des couches 53, 47 et 51. La couche 55 est par exemple en un matériau diélectrique. La couche d'isolation 55 est par exemple en un nitrure, par exemple en nitrure de silicium.

Les éléments mémoires M de lignes de bits voisines sont par exemple isolées les unes des autres par une couche isolante 59. La couche isolante 59 est, par exemple, en un matériau ayant une faible constante diélectrique. En variante, la couche 59 est en un oxyde, par exemple en dioxyde de silicium.

Ainsi, dans le mode de réalisation des figures 1A à 1C, chaque élément mémoire M est connecté électriquement au transistor de sélection 12 auquel il est associé par l'intermédiaire d'un via conducteur 63 traversant tous les niveaux de l'empilement d'interconnexion 35. A titre d'exemple, le via 63 traverse l'ensemble des couches isolantes 37 et 39 de l'empilement d'interconnexion 35 situés entre la couche 45 et la couche 18.

A titre d'exemple, le via 63 associé à chaque élément mémoire M est en contact, par sa face supérieure, avec la face inférieure de l'élément résistif chauffant 49 de l'élément mémoire M. Le via 63 est par exemple en contact, par sa face inférieure, avec un via conducteur 22, lui-même en contact avec la face supérieure de la région 27 du transistor 12 associé à l'élément mémoire M. Autrement dit, pour chaque élément mémoire M, le via 63 correspondant relie électriquement l'élément chauffant 49 de la cellule mémoire à la région 27 sous-jacente.

Le via conducteur 63 est par exemple en un matériau métallique. Le via conducteur 63 est par exemple en tungstène. En variante, le via conducteur est en cobalt ou en cuivre. Le via conducteur 63 a, par exemple, une largeur, prise dans le plan de la figure 1A et dans le plan de la figure 1B, comprise entre 20 nm et 100 nm, par exemple de l'ordre de 40 nm.

A titre d'exemple, les vias 69 se prolongent, sous la couche 47, à l'extérieur du circuit mémoire pour y être connectés et pouvoir appliquer des potentiels aux lignes de mots des éléments mémoires M.

A titre d'exemple, la couche 53 est connectée, par sa face supérieure, à un élément conducteur pour pouvoir appliquer des potentiels aux lignes de bits des éléments mémoires M.

La figure 2, la figure 3, la figure 4, la figure 5, la figure 6, la figure 7A, la figure 7B, la figure 7C, la figure 7D, la figure 8A, la figure 8B, la figure 9A, la figure 9B, la figure 10A, la figure 9B, la figure 10A, la figure 10B, la figure 11A, la figure 11B, la figure 12A, la figure 12B, la figure 13A, la figure 13B, la figure 14A, la figure 14B, la figure 15A, la figure 15B, la figure 16A et la figure 16B sont des vues illustrant des étapes d'un exemple de procédé de fabrication du dispositif électronique des figures 1A, 1B et 1C.

Plus particulièrement, les figures 2 à 16B sont des vues illustrant un procédé de fabrication simultanée, ou en cointégration dans un même dispositif de circuits intégrés, du circuit mémoire de la puce 11 illustré en figures 1A à 1C comportant des transistors bipolaire de sélection et d'un circuit logique, par exemple adjacent au circuit mémoire, comportant des transistors à effet de champ à ailettes (FinFET, de l'anglais "fin Field-Effect Transistor"). Sur les figures 2 à 16B, sont représentées deux régions a) et b) du dispositif dans lesquelles sont formés respectivement deux transistors bipolaires de sélection et deux transistors FinFET. On comprendra qu'en pratique, la région a) peut comporter un nombre de transistors bipolaires de sélection supérieur à deux et la région b) peut comporter un nombre de transistors FinFET supérieur à deux.

La figure 2 illustre, par une vue en coupe partielle et schématique, une structure de départ comportant le substrat semiconducteur 13. En figure 2, le substrat 13 comprend la première région a) dans et sur laquelle est formé un transistor FinFET au cours du procédé décrit ci-après et la deuxième région b) dans et sur laquelle est formé un transistor bipolaire de sélection au cours du procédé décrit ci-après.

La figure 3 illustre, par une vue en coupe partielle et schématique, une structure obtenue à l'issue d'une étape de formation de tranchées 60 dans la première région a) du substrat 13 de la figure 2.

La formation des tranchées 60 permet de définir, entre les tranchées 60, les ailettes des transistors FinFET. A titre d'exemple, les tranchées 60 s'étendent dans la direction des lignes de bits, c'est-à-dire dans la direction orthogonale à la direction du plan de coupe de la figure 3.

Les tranchées 60 s'étendent par exemple dans le substrat 13, à partir de la face supérieure du substrat 13.

A titre d'exemple, les tranchées 60 n'ont pas, en vue en coupe une forme rectangulaire dont le fond est orthogonal aux faces latérales. Les tranchées 60 ont, par exemple, en vue en coupe une forme trapézoïdale dans laquelle la largeur des tranchées 60 au niveau de la face supérieure des tranchées 60 est supérieure à la largeur des tranchées 60 au niveau de la face inférieure des tranchées 60. A titre d'exemple, les tranchées ont un pas compris entre 20 nm et 100 nm, par exemple compris entre 30 nm et 50 nm. A titre d'exemple, les tranchée 60 ont une largeur, prise au niveau de la face supérieure du substrat 13, comprise entre 10 nm et 90 nm, par exemple comprise entre 20 nm et 40 nm. A titre d'exemple, les tranchées 60 s'étendent sur une profondeur comprise entre 20 nm et 400 nm, par exemple comprise entre 100 nm et 200 nm, par exemple de l'ordre de 150 nm. Les tranchées 60 définissent les ailettes des transistors qui ont, par exemple une largeur comprise entre 2 nm et 30 nm, par exemple comprise entre 5 nm et 15 nm, par exemple comprise entre 7 nm et 8 nm.

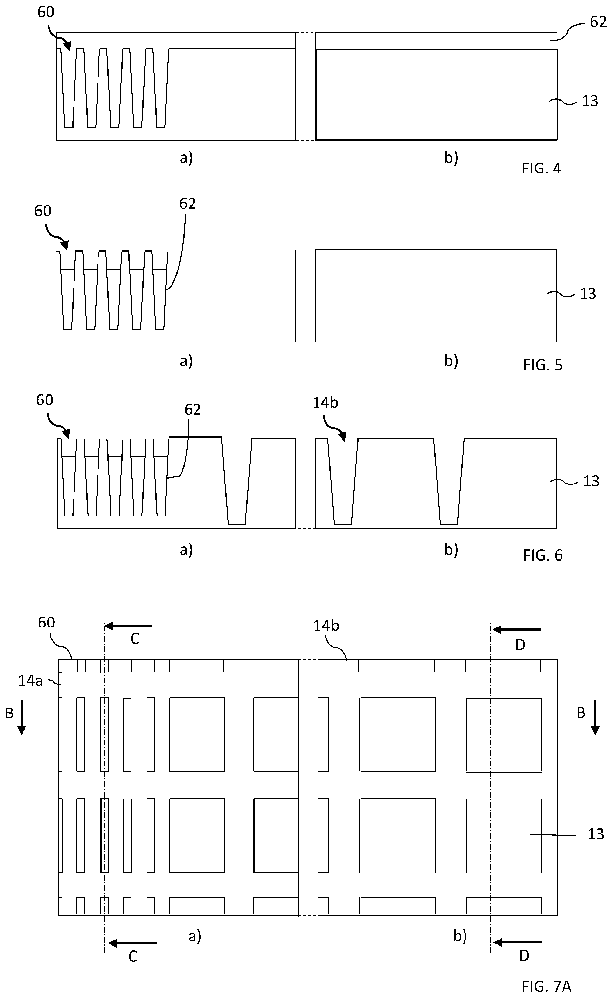

La figure 4 illustre, par une vue en coupe partielle et schématique, une structure obtenue à l'issue d'une étape de dépôt d'une couche 62 sur la face supérieure de la structure illustrée en figure 3.

Plus particulièrement, lors de cette étape, la couche 62 est déposée sur la face supérieure du substrat 13 et dans les tranchées 60. A titre d'exemple, lors de cette étape, la couche 62 vient recouvrir intégralement la face supérieure du substrat 13. La couche 62 est par exemple une couche en un matériau diélectrique, par exemple en un oxyde.

La figure 5 illustre, par une vue en coupe partielle et schématique, une structure obtenue à l'issue d'une étape de retrait de la couche 62 sur une partie supérieure de la structure illustrée en figure 4.

Plus particulièrement, dans un premier temps, la couche 62 est retirée de la face supérieure du substrat 13 de façon à dévoiler la face supérieure du substrat 13. Ce retrait est par exemple effectué par un retrait ou polissage mécanochimique (CMP, de l'anglais "Chemical Mechanical Polishing") . Le retrait de la couche 62 est par exemple arrêté lorsque la face supérieure du substrat 13 est dévoilée.

Dans un second temps, lors de cette étape, la couche 62 est retirée sur une partie supérieure dans les tranchées 60 de façon à ne conserver la couche 62 que dans une partie inférieure des tranchées 60. Ce retrait est par exemple effectué sur une profondeur comprise entre 10 nm et 100 nm, par exemple de l'ordre de 50 nm.

La figure 6 illustre, par une vue en coupe partielle et schématique, une structure obtenue à l'issue d'une étape de formation des tranchées 14b dans le substrat 13 de la figure 5.

Les tranchées 14b sont, par exemple, formées dans le substrat 13 en s'étendant, dans le substrat 13, à partir de la face supérieure du substrat 13. A titre d'exemple, les tranchées 14b s'étendent sur une profondeur supérieure à la profondeur des tranchées 60. Les tranchées 14b sont par exemple formées dans le substrat 13 dans la première a) et la deuxième région b) du substrat 13. A titre d'exemple, les tranchées 14b permettent d'isoler, pour certaines situées dans le circuit mémoire, les lignes de bits voisines et d'isoler, pour d'autres situées entre le circuit logique et le circuit mémoire, le circuit logique du circuit mémoire.

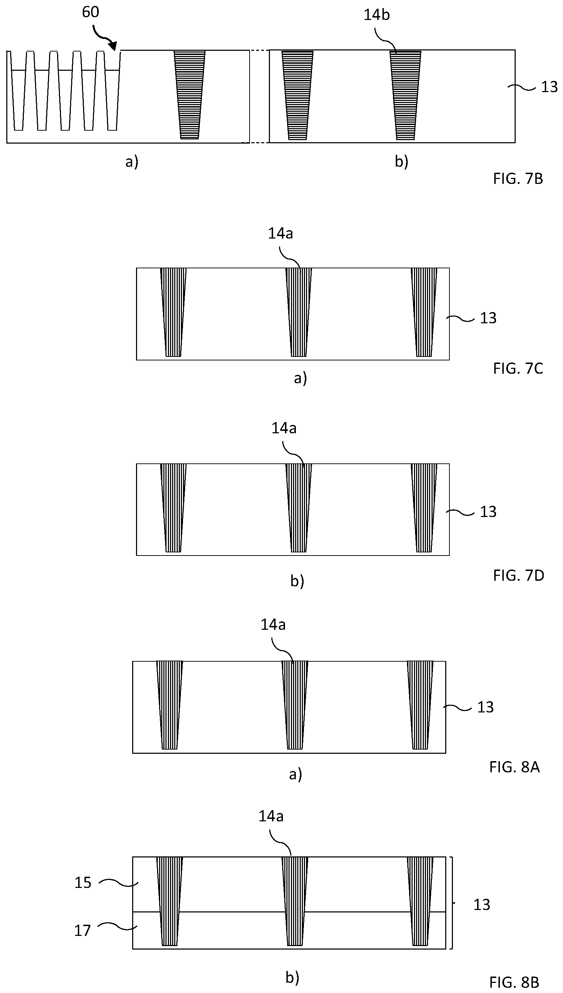

Les figures 7A, 7B, 7C et 7D illustrent par des vues partielles et schématique, une structure obtenue à l'issue d'une étape de formation des tranchées 14a dans le substrat 13 de la figure 6. Plus particulièrement, les figures 7B, 7C et 7D sont des vues en coupe et la figure 7A est une vue de dessus de la structure obtenue à l'issue de l'étape de formation des tranchées 14a dans le substrat 13 de la figure 6, la figure 7B étant une vue en coupe selon le plan de coupe BB de la figure 7A, la figure 7C étant une vue en coupe selon le plan de coupe CC de la figure 7A et la figure 7D étant une vue en coupe selon le plan de coupe DD de la figure 7A. La figure 7C correspond en outre à une vue en coupe dans la première région a) du substrat 13 et la figure 7D correspond à une vue en coupe dans la deuxième région b) du substrat 13.

Les tranchées 14a sont, par exemple, formées dans le substrat 13 en s'étendant, dans le substrat 13, à partir de la face supérieure du substrat 13. A titre d'exemple, les tranchées 14a s'étendent sur une profondeur supérieure à la profondeur des tranchées 60. Les tranchées 14a sont par exemple formées dans le substrat 13 dans la première a) et la deuxième région b) du substrat 13. A titre d'exemple, les tranchées 14a permettent d'isoler les lignes de mots voisines. A titre d'exemple, une même tranchée 14a peut à la fois s'étendre dans la première région a) du substrat 13 et dans la deuxième région b) du substrat 13. En variante, une même tranchée 14a peut ne s'étendre que dans la première région a) du substrat 13 ou que dans la deuxième région b) du substrat 13. Encore en variante, une même tranchée 14a peut s'étendre que sur une portion seulement de la première région a) du substrat 13 et/ou sur une portion seulement de la deuxième région b) du substrat 13.

A titre d'exemple, la formation des tranchées 14 comporte une étape préalable de dépôt d'une couche de protection, par exemple en nitrure, permettant la protection de la structure dans les zones n'accueillant pas de tranchées 14. A titre d'exemple, à l'issue de la formation des tranchées 14a et 14b, celles-ci sont par exemple remplies d'un matériau semiconducteur. A titre d'exemple, les tranchées 14a et 14b sont remplies d'un oxyde. L'étape de remplissage des tranchées 14a et 14b est par exemple suivie d'une étape de CMP s'arrêtant sur la face supérieure de la couche de protection susmentionnée. A titre d'exemple, le cas échéant, après l'étape de CMP, la couche de protection est retirée de façon à dévoiler la face supérieure du substrat 13.

Bien que l'on ait décrit dans le présent mode de réalisation que les tranchées 14a et 14b sont remplies du matériau diélectrique lors d'une unique étape, on peut prévoir que le remplissage des tranchées 14b soient réalisé, à l'issue de l'étape illustrée en figure 6, avant la formation des tranchées 14a.

De plus, bien que l'on ait décrit dans le présent mode de réalisation que les tranchées 14b sont réalisées avant les tranchées 14a, on peut prévoir que l'ordre de réalisation de ces tranchées soit inversé et que les tranchées 14a soient réalisées avant les tranchées 14b.

A titre d'exemple, bien que cela ne soit pas représenté, à l'issue de la formation des tranchées 14a et 14b, la structure est recouverte par une couche en un matériau diélectrique, par exemple en un oxyde. La couche d'oxyde recouvre ainsi la face supérieure du substrat 13 dans les première a) et deuxième b) régions, la face supérieure des tranchées 14a et 14b, la face supérieure de la couche 62 dans les tranchées 60 et les flancs des tranchées 60 au dessus de la couche 62.

Les figures 8A et 8B illustrent par des vues en coupe, partielles et schématiques, une structure obtenue à l'issue d'une étape de formation des couches 15 et 17 dans la deuxième région b) du substrat 13 de la structure illustrée aux figures 7A à 7D.

Plus particulièrement, la figure 8A illustre une vue en coupe selon un plan de coupe identique à celui de la figure 7C, c'est-à-dire une coupe dans la région a) du substrat 13 où les transistors FinFET sont formés et la figure 8B illustre un vue en coupe selon un plan de coupe identique à celui de la figure 7D, c'est-à-dire une coupe dans la région b) du substrat 13 où les transistors bipolaires de sélection sont formés.

A titre d'exemple, lors de cette étape, on vient doper le substrat 13 de façon à créer, dans une partie supérieure du substrat 13, la couche 15 dopée du type N et, dans une partie inférieure du substrat 13, la couche 17 dopée du type P. A titre d'exemple, l'implantation est, lors de cette étape, réalisée de sorte que la jonction entre la couche 15 et la couche 17 soit moins profonde que les tranchées 14a et 14b.

A titre d'exemple, cette étape est réalisée seulement dans la deuxième région b) du substrat 13. La première région a) du substrat 13 ne comprend, à l'issue de cette étape, pas de couches 15 et 17.

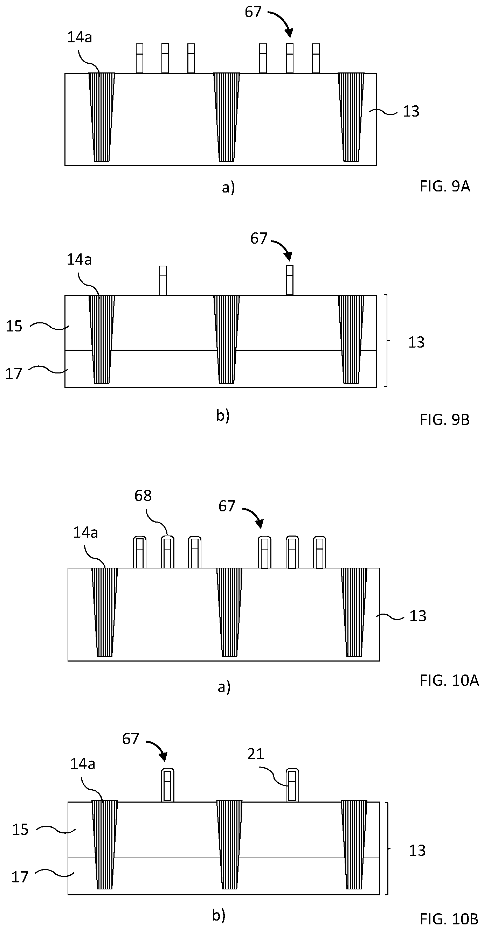

Les figures 9A et 9B illustrent par des vues en coupe, partielles et schématiques, une structure obtenue à l'issue d'une étape de formation de grilles sacrificielles 67 à la surface de la structure illustrée en figures 8A et 8B.

Plus particulièrement, lors de cette étape, on vient former les grilles sacrificielles 67 sur la face supérieure du substrat 13 dans la première région a) et dans la deuxième région b). Les grilles 67 comportent par exemple un matériau dit sacrificiel. A titre d'exemple, les grilles 67 comportent une couche semiconductrice, par exemple en silicium polycristallin. A titre d'exemple, les grilles 67 comportent, en outre, sur la couche semiconductrice, une couche diélectrique, par exemple en nitrure de silicium.

Les grilles 67 sont par exemple formées par dépôt des couches susmentionnées pleine plaque avant d'être gravées.

Les figures 10A et 10B illustrent par des vues en coupe, partielles et schématiques, une structure obtenue à l'issue d'une étape de formation d'espaceurs 21 et 68 sur la structure illustrée en figures 9A et 9B.

Plus particulièrement, lors de cette étape, on vient former les espaceurs 68 sur la première région a) du substrat 13 illustrée en figure 9A et former les espaceurs 21 sur la deuxième région b) du substrat 13 illustrée en figure 9B, la formation des espaceurs 68 étant illustrée en figure 10A et la formation des espaceurs 21 étant illustrée en figure 10B.

A titre d'exemple, les espaceurs 68 et 21 sont formés au sein d'une seule et même étape par dépôt d'une couche sur la face supérieure de la structure illustrée en figures 9A et 9B. Lors de cette étape, ladite couche recouvre la face supérieure du substrat 13 dans les première a) et deuxième b) régions et les flancs et la face supérieure des grilles 67.

En variante, les espaceurs 68 et 21 sont formés lors de deux étapes successives. A titre d'exemple, on peut prévoir que les espaceurs 68 sont formés par dépôt d'une couche sur la face supérieure du substrat 13 alors que la deuxième région b) est masquée. Les espaceurs 21 sont similairement formés par dépôt d'une couche sur la face supérieure du substrat 13 alors que la première région a) est masquée.

A titre d'exemple, sur la face supérieure du substrat 13, la ou les couches formant les espaceurs 68 et 21 sont, par exemple, à l'issue de cette étape, retirées de façon à n'être conservées qu'au contact des grilles 67.

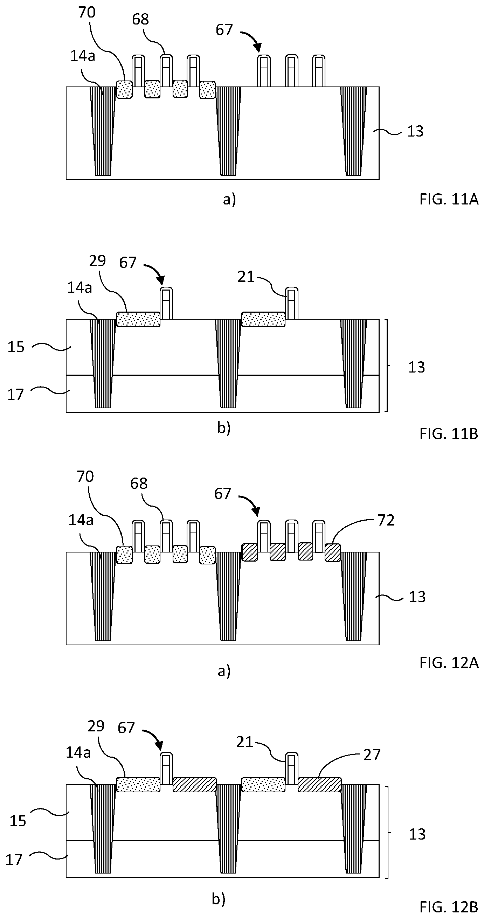

Les figures 11A et 11B illustrent par des vues en coupe, partielles et schématiques, une structure obtenue à l'issue d'une étape de formation de régions 70 et 29 sur et dans le substrat 13 de la structure illustrée en figures 10A et 10B.

Plus particulièrement, lors de cette étape, on vient former les régions 70 dans la première région a) du substrat 13 illustrée en figure 10A et former les régions 29 dans la deuxième région b) du substrat 13 illustrée en figure 10B, la formation des régions 70 étant illustrée en figure 11A et la formation des régions 29 étant illustrée en figure 11B.

A titre d'exemple les régions 70 et 29 sont formées par épitaxie puis par implantation d'atomes dopants de type N. Les régions 70 et 29 ont, par exemple, leurs faces supérieures décalées par rapport à la face supérieure du substrat 13. A titre d'exemple, la face supérieure des régions 70 et 29 est en avant par rapport à la face supérieure du substrat 13, en vis-à-vis des grilles 67.

Les régions 70 s'étendent par exemple longitudinalement entre des grilles 67 et entre des grilles 67 et des tranchées 14a. Les régions 29 s'étendent, par exemple, entre les grilles 67 et les tranchées 14a seulement d'un des deux côtés de chaque grille 67.

A titre d'exemple, les régions 70 et 29 sont formées au sein d'une seule et même étape. En variante, les régions 70 et 29 sont formées lors de deux étapes successives.

A titre d'exemple, les régions 70 correspondent aux futures régions de source et de drain des transistors FinFET NMOS. Dans une telle structure, le drain d'un transistor correspond à la source du transistor voisin.

Les figures 12A et 12B illustrent par des vues en coupe, partielles et schématiques, une structure obtenue à l'issue d'une étape de formation de régions 72 et 27 sur et dans la structure illustrée en figures 11A et 11B.

Plus particulièrement, lors de cette étape, on vient former les régions 72 dans la première région a) du substrat 13 illustrée en figure 11A et former les régions 27 dans la deuxième région b) du substrat 13 illustrée en figure 11B, la formation des régions 72 étant illustrée en figure 12A et la formation des régions 27 étant illustrée en figure 12B.

A titre d'exemple les régions 72 et 27 sont formées par épitaxie puis par implantation d'atomes dopants de type P. Les régions 72 et 27 ont, par exemple, leurs faces supérieures décalées par rapport à la face supérieure du substrat 13. A titre d'exemple, la face supérieure des régions 72 et 27 est en avant par rapport à la face supérieure du substrat 13.

Les régions 72 s'étendent par exemple longitudinalement entre des grilles 67 et entre des grilles 67 et des tranchées 14a. Les régions 27 s'étendent, par exemple, entre les grilles 67 et les tranchées 14a seulement d'un des deux côtés de chaque grille 67.

A titre d'exemple, les régions 72 et 27 sont formées au sein d'une seule et même étape. En variante, les régions 72 et 27 sont formées lors de deux étapes successives.

A titre d'exemple, les régions 72 correspondent aux futures régions de source et de drain des transistors FinFET PMOS. Dans une telle structure, le drain d'un transistor correspond à la source du transistor voisin.

A titre d'exemple, à l'issue des étapes des figures 11 et 12, dans et sur la première région a) du substrat 13, des zones s'étendant entre deux tranchées 14a ont leurs grilles 67 entourées uniquement de régions 70 de façon à y former des transistors de type NMOS ou métal-oxyde-semiconducteur à canal N (de l'anglais "metal-oxide-semiconductor"). Similairement, à titre d'exemple, à l'issue des étapes des figures 11 et 12, dans et sur la première région a) du substrat 13, des zones s'étendant entre deux tranchées 14a ont leurs grilles 67 entourées uniquement de régions 72 de façon à y former des transistors de type PMOS ou métal-oxyde-semiconducteur à canal P.

A titre d'exemple, à l'issue des étapes des figures 11 et 12l es grilles 67 sont, dans et sur la deuxième région b), entourées d'une part de régions 29 et d'autre part de régions 27.

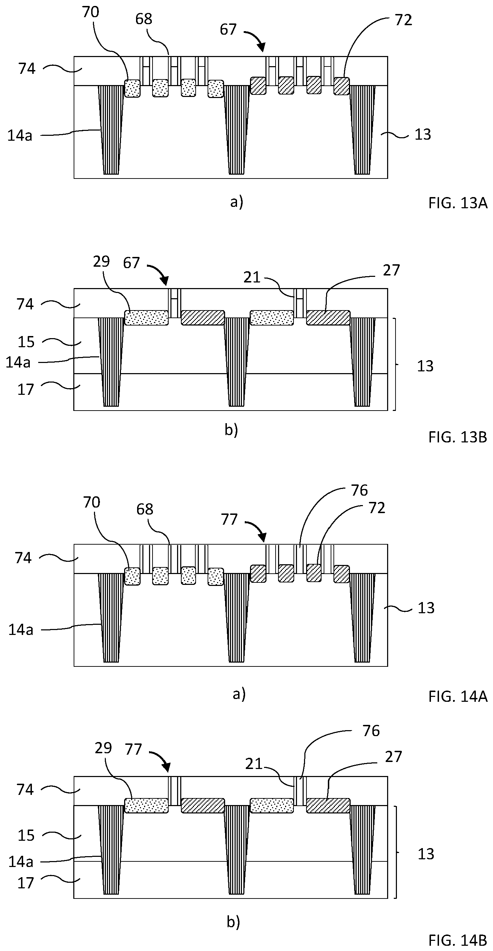

Les figures 13A et 13B illustrent par des vues en coupe, partielles et schématiques, une structure obtenue à l'issue d'une étape de formation d'une couche 74 sur la face supérieure de la structure illustrée en figures 12A et 12B et d'une étape de polissage de la structure ainsi obtenue.

Plus particulièrement, lors de cette étape, on vient dans un premier temps former la couche 74 sur la face supérieure de la structure illustrée en figures 12A et 12B en recouvrant la face supérieure du substrat 13, dans sa première a) et sa deuxième b) région, les faces supérieures des régions 70, 72, 27 et 29 et les grilles 67.

Dans un second temps, la structure ainsi obtenue subit une CMP de façon à retirer une partie supérieure de la couche 74 et dévoiler la face supérieure des grilles 67. Lors de cette étape, une partie supérieure des espaceurs 68 et 21 est en outre retirée avec la couche 74. A l'issue de cette étape, les espaceurs subsistent uniquement sur les flancs des grilles 67. A l'issue de cette étape, la face supérieure des grilles 67 affleurent la face supérieure de la couche 74.

Les figures 14A et 14B illustrent par des vues en coupe, partielles et schématiques, une structure obtenue à l'issue d'une étape de retrait des grilles sacrificielles 67 de la structure illustrée en figures 13A et 13B et du remplissage des ouvertures ainsi formées par une couche 76.

Plus particulièrement, lors de cette étape, dans un premier temps, le matériau constituant les grilles 67 est retiré. Des ouvertures, dans la couche 74, entourées des espaceurs 68 et 21 et débouchant sur la face supérieure du substrat 13 sont alors crées. On dit que les grilles 67 sont ainsi "vidées".

Dans un second temps, on vient déposer sur la face supérieure de la structure ainsi formée une couche 76. A titre d'exemple, la couche 76 est déposée sur la face supérieure de la structure de sorte que les ouvertures formées à la place des grilles 67 soient remplies par la couche 76. La couche 76 est par exemple une couche en un matériau métallique, par exemple en nitrure de titane, nitrure de tantale et/ou en tungstène. A titre d'exemple, la couche 76 comprend plusieurs sous-couches d'un ou plusieurs des matériaux susmentionnés. A titre d'exemple, le dépôt de la couche 76 dans les ouvertures formées à la place des grilles 67 est précédé d'une étape de dépôt, dans ces mêmes ouvertures, d'un oxyde et d'un matériau diélectrique de haute permittivité diélectrique.

A titre d'exemple, à l'issue de cette étape, la structure subit une étape de CMP de façon à dévoiler la face supérieure de la couche 74 de sorte que la couche 76 ne subsiste que dans les ouvertures.

A l'issue de cette étape, la couche 76 correspond, dans les ouvertures de la couche 74, à des grilles métalliques 77.

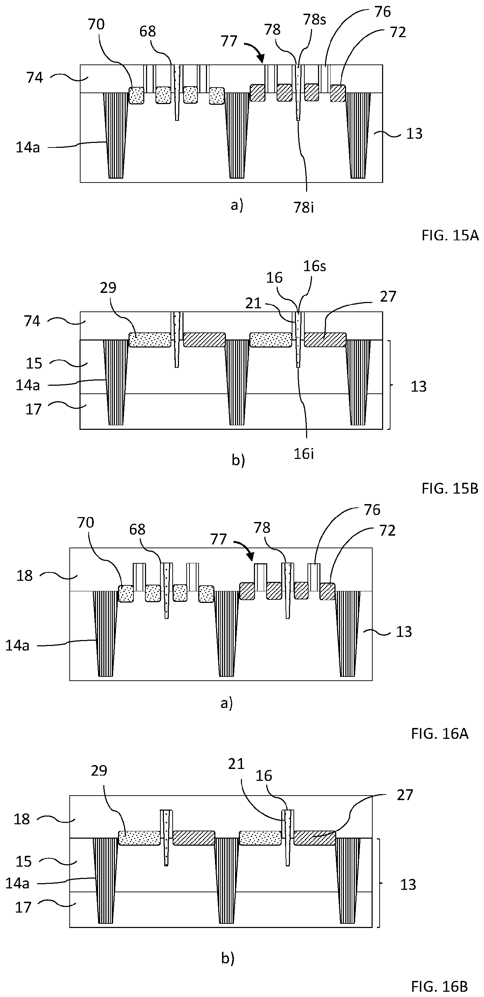

Les figures 15A et 15B illustrent par des vues en coupe, partielles et schématiques, une structure obtenue à l'issue d'une étape de formation de tranchées 16 et 78 dans la structure illustrée en figures 14A et 14B.

Plus particulièrement, lors de cette étape, on vient former les tranchées 78 dans et en vis-à-vis de la première région a) du substrat 13 illustrée en figure 14A et former les tranchées 16 dans et en vis-à-vis de la deuxième région b) du substrat 13 illustrée en figure 14B, la formation des tranchées 78 étant illustrée en figure 15A et la formation des tranchées 16 étant illustrée en figure 15B.

Lors de cette étape, les tranchées 78 et 16 sont par exemple, formées à la place de certaines des grilles métalliques 77. Plus précisément, les tranchées 78 sont par exemple formées à la place uniquement de certaines des grilles métalliques 77 de la première région a) du substrat 13 et les tranchées 16 sont formées à la place de toutes les grilles métalliques 77 de la deuxième région b) du substrat 13.

Les tranchées 78 et 16 sont par exemple formées par retrait du matériau métallique contenu dans les grilles 77. A l'issue de l'étape de retrait, les ouvertures ainsi créées sont, par exemple, prolongées en profondeur dans le substrat 13, sans déboucher dans le couche 17. A l'issue de cette étape, les ouvertures prolongées sont remplies d'un matériau diélectrique, par exemple un oxyde.

L'étape de remplissage des ouvertures en le matériau diélectrique est par exemple suivie par une étape de CMP de façon à ne pas laisser subsister du matériau susmentionné sur la face supérieure de la couche 74.

A titre d'exemple, à l'issue de cette étape, les tranchées 16 et 78 correspondent à des structures de rupture de diffusion unique (SDB, de l'anglais "Single Diffusion Break").

Les tranchées 16 et 78 ont par exemple la même profondeur.

En variante, les tranchées 16 et 78 ont des profondeurs différentes.

A titre d'exemple, dans la première région a) du substrat 13, les tranchées 78 isolent, dans la partie gauche de la figure 15A, deux transistors FinFET NMOS et dans la partie droite de la figure 15A, deux transistors FinEFT PMOS.

Les figures 16A et 16B illustrent par des vues en coupe, partielles et schématiques, une structure obtenue à l'issue d'une étape de retrait de la couche 74 de la structure illustrée en figures 15A et 15B et de dépôt de la couche isolante 18 sur la structure ainsi formée.

Lors de cette étape, la couche 74 est par exemple retirée et la couche isolante 18 est par exemple déposée sur la face supérieure de la structure. A titre d'exemple, la couche 18 est déposée en vis à vis des première a) et deuxième b) régions du substrat 13.

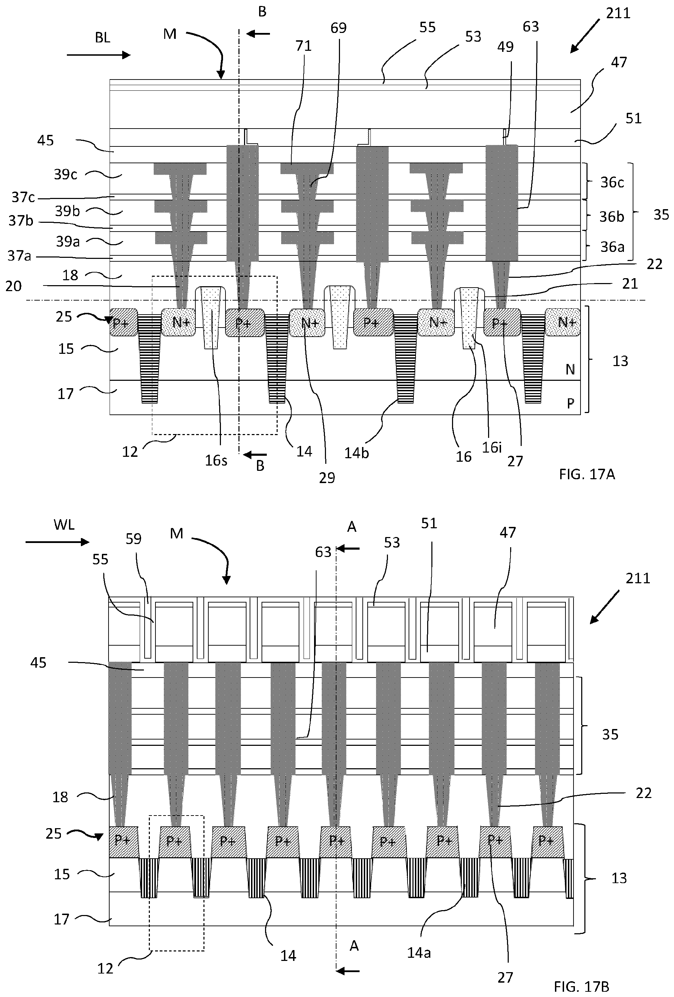

La figure 17A et la figure 17B sont des vues en coupe, partielles et schématiques, d'un exemple d'un dispositif électronique 211 selon un deuxième mode de réalisation, la figure 17A étant une vue en coupe selon le plan de coupe AA de la figure 17B et la figure 17B étant une vue en coupe selon le plan de coupe BB de la figure 17A.

Plus particulièrement, les figures 17A et 17B sont des vues illustrant un dispositif électronique 211 différent du dispositif 11 illustré en relation avec les figures 1A à 1C à la différence près que, dans le dispositif 211, les tranchées 14a ne sont pas des tranchées STI mais sont des tranchées dites FIN formées similairement aux tranchées 60 définissant les ailettes des transistors FinFET.

A titre d'exemple, les tranchées 14a du dispositif 211 sont ainsi moins profondes que les tranchées 14a du dispositif 11. De plus, les tranchées 14a du dispositif 211 sont, par exemple, moins large que les tranchées 14a du dispositif 11. En outre, les tranchées 14a du dispositif 211 ont, par exemple, un pas de répétition supérieur au pas de répétition des tranchées 14a du dispositif 11. Dans ce mode de réalisation, les tranchées définissent des ailettes qui ont une largeur comprise entre 15 nm et 50 nm, par exemple comprise entre 20 nm et 30 nm, par exemple de l'ordre de 25 nm. Dans ce mode de réalisation, les éléments mémoire M sont ainsi plus rapprochés dans le dispositif 211 que dans le dispositif 11.

Le dispositif 211 a, par exemple un procédé de fabrication compatible avec le procédé de fabrication du dispositif 11 décrit en relation avec les figures 2 à 16B à la différence près que les tranchées 14b sont formées similairement aux tranchées 60, par exemple avant, après ou en même temps que les tranchées 60. Le procédé de fabrication du dispositif 211 diffère en outre du procédé décrit ci-avant en ce que l'étape décrite en relation avec la figure 6 est omise. A titre d'exemple, dans ce mode de réalisation, la couche 15 peut s'étendre plus profondément que les tranchées 14a. Ainsi les tranchées 14a ne débouchent donc pas dans la couche 17.

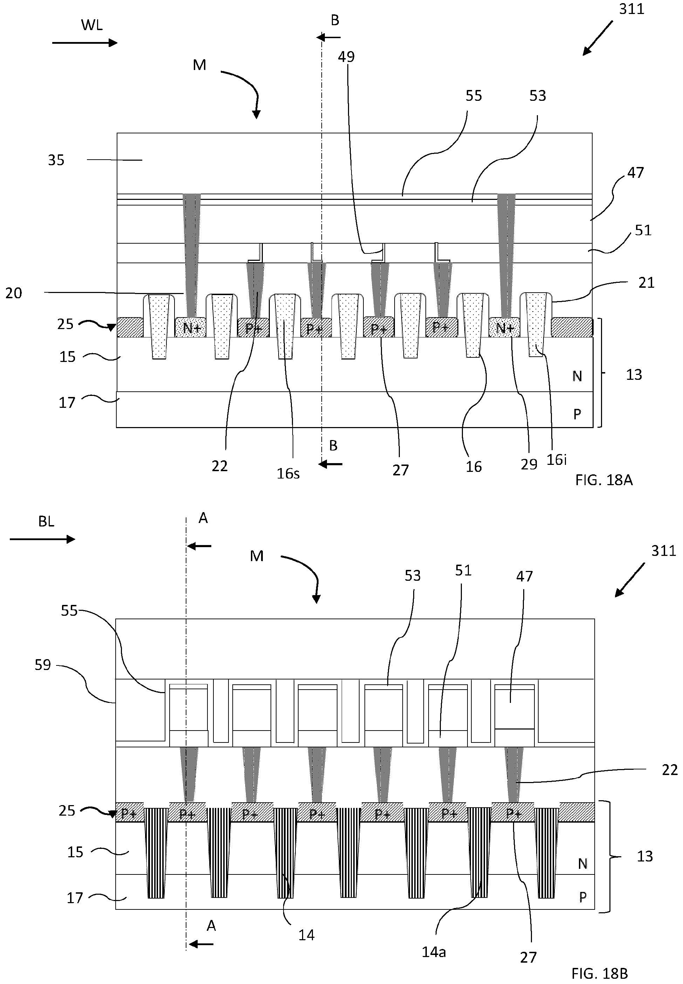

La figure 18A et la figure 18B sont des vues, partielles et schématiques, d'un exemple d'un dispositif électronique selon un troisième mode de réalisation la figure 18A étant une vue en coupe selon le plan de coupe AA de la figure 18B et la figure 18B étant une vue en coupe selon le plan de coupe BB de la figure 18A.

Plus particulièrement, les figures 18A et 18B sont des vues illustrant un dispositif électronique 311 différent du dispositif 11 illustré en relation avec les figures 1A à 1C en ce que, dans le dispositif 311, il n'y pas de reprise de contact par les pistes 71 et les vias 69 pour chaque cellule mémoire. De plus, dans ce mode de réalisation, les couches 47 et 53 s'étendent dans la direction des lignes de mots et les éléments métalliques 49 s'étendent dans la direction des lignes de bits. En outre, le dispositif électronique 311 est différent du dispositif 11 illustré en relation avec les figures 1A à 1C en ce que les éléments mémoires M sont formés entre le réseau d'interconnexion 35 et le substrat 13. Dans ce mode de réalisation, la couche 25 ne comprend pas d'alternance de régions 27 et 29 et il n'y a donc pas de tranchées 14b.

A titre d'exemple, dans ce mode de réalisation, des tranchées 16 sont présentes pour séparer deux régions 27 voisines et pour séparer les régions 27 de régions 29 voisines.

Un avantage du présent mode de réalisation est qu'il permet d'intégrer, au sein d'un seul et même dispositif électronique, des transistors FinFET et des transistors bipolaires de sélection tout en étant compatible avec les procédés de fabrication usuels des transistors FinFET et bipolaire de sélection. En effet, le présent mode de réalisation permet la formation des tranchées 16 dans un transistor bipolaire de sélection à l'aide d'étapes présentes dans le procédé usuel de fabrication des transistors FinFET.

De nombreuses applications sont susceptibles de tirer profit des avantages procurés par le dispositif électronique 11, dispositif électronique 11 pouvant ainsi être intégré dans divers types de dispositifs.

À titre d'exemple, le dispositif électronique 11 peut être intégré dans un dispositif destiné à l'industrie automobile. L'électrification des véhicules automobiles cause une forte augmentation du nombre de composants électroniques présents dans les véhicules. Le dispositif comprend par exemple des thyristors, des redresseurs, des diodes de suppression de tensions transitoires, des modules, etc. destinés à être incorporés dans lesdits véhicules. Par ailleurs, l'aide à la conduite et l'automatisation de la conduite sont à l'origine d'une augmentation du nombre de composants électroniques dans les véhicules. Le dispositif comprend par exemple des diodes de suppression de tensions transitoires, une protection contre les décharges électrostatiques et des filtres de mode commun permettant de protéger le dispositif contre des risques électriques.

À titre d'exemple, le dispositif électronique 11 peut être intégré dans un dispositif destiné à l'industrie. En particulier, le dispositif est par exemple utilisé pour le développement des énergies vertes ou pour l'électrification d'infrastructures, par exemple pour des bornes de recharge ou pour la collecte d'énergie solaire. Le dispositif peut également être utilisé dans le domaine de l'internet des objets ou dans le domaine des maisons connectées. Le dispositif est par exemple destiné à être mis en œuvre dans des circuits d'alimentation en énergie électrique d'équipements, comprenant par exemple des thyristors 800 V ou 1 200 V, des diodes 1 200 V ultrarapides et au carbure de silicium, des diodes de suppression de tensions transitoires et des protections contre les décharges électrostatiques. Le dispositif peut également être utilisé pour la mise en œuvre de systèmes d'informatique dans le nuage, de réseaux de communication radiofréquence 5G, de centres de données et de serveurs. Le dispositif comprend par exemple des matériaux à large bande interdite.

À titre d'exemple, le dispositif électronique 11 peut être intégré dans un dispositif destiné à être utilisé dans l'électronique personnelle, par exemple dans le but d'augmenter un volume d'informations échangées par communication radiofréquence, dans des systèmes de communication 5G, ou plus généralement dans tout dispositif connecté. Le dispositif est par exemple un téléphone mobile, ou smartphone, ou fait partie d'un réseau de l'internet des objets. Le dispositif est par exemple connecté par 5G, par WiFi ou par communication large bande. Le dispositif comprend par exemple des interfaces à haut débit, par exemple avec un filtrage avancé et une protection contre les décharges électrostatiques.

À titre d'exemple, le dispositif électronique 11 peut être intégré dans un dispositif destiné à être utilisé dans des équipements de communication, ou dans des ordinateurs et des périphériques. Le dispositif est par exemple utilisé dans des infrastructures 5G et des centres de données dédiés. Le dispositif comprend par exemple des diodes en carbure de silicium, des transistors de puissance Schottky, des protections contre les décharges électrostatiques et des diodes de suppression des tensions transitoires. Le dispositif peut également être utilisé dans des satellites comprenant par exemple des dispositifs passifs intégrés pour des applications radiofréquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les deuxième et troisième modes de réalisation respectivement illustrés en figures 17A et 17B et en figures 18A et 18B sont compatibles.

De plus, bien que l'on ait décrit des modes de réalisation dans lesquels les éléments mémoires M sont formés au dessus de l'empilement d'interconnexion 35, les modes de réalisation ne se limitent pas à ce cas particulier. A titre de variante, les éléments mémoires M peuvent être formés entre l'empilement d'interconnexion 35 et le substrat 13.

En outre, bien que l'on ait décrit un mode de réalisation dans lequel les régions 70 et 29 sont réalisées dans le substrat 13 avant les régions 72 et 27, on peut prévoir d'inverser la réalisation de ces régions. Similairement, bien que l'on ait décrit un mode de réalisation dans lequel les tranchées 14b sont réalisées dans le substrat 13 avant les tranchées 14a, on peut prévoir d'inverser la réalisation de ces tranchées.

Enfin, la mise en oeuvre pratique des modes de réalisation et variantes décrits est à la portée de la personne du métier à partir des indications fonctionnelles données ci-dessus.

## Revendications

1. Dispositif électronique (11 ; 211 ; 311) comportant :
- un substrat semiconducteur (13) ;
- une couche isolante (18) recouvrant le substrat semiconducteur, sur et en contact avec le substrat semiconducteur ; et
- un circuit mémoire comportant une pluralité de cellules mémoire, comprenant chacune un transistor bipolaire de sélection (12) disposé dans et sur le substrat semiconducteur, chaque transistor bipolaire de sélection comportant, une région de base (29, 15), une région d'émetteur (27) et une région de collecteur (17),
dans lequel chaque transistor bipolaire de sélection comprend une structure d'isolation (16) en un premier matériau diélectrique, la structure d'isolation comportant une partie supérieure (16s) s'étendant verticalement dans la couche isolante (18) et une partie inférieure (16i) s'étendant verticalement dans le substrat semiconducteur (13) entre la région de base (29) et la région d'émetteur (27), les faces latérales de la partie supérieure (16s) de la structure d'isolation (16) étant recouvertes par des espaceurs (21) en un deuxième matériau diélectrique.

2. Dispositif selon la revendication 1, comportant en outre un circuit logique comportant une pluralité de transistors à effet de champ à ailettes disposé dans et sur le substrat semiconducteur, chaque transistor à effet de champ à ailettes comportant, une région de source (70, 72) et une région de drain (70, 72),
dans lequel deux transistors à effet de champ à ailettes voisins sont séparés par une autre structure d'isolation (78) en le premier matériau diélectrique, la structure d'isolation comportant une partie supérieure (78s) s'étendant verticalement dans la couche isolante et une partie inférieure (78i) s'étendant verticalement dans le substrat semiconducteur entre la région de drain et la région de source des deux transistors voisins, les faces latérales de la partie supérieure (78s) de la structure d'isolation étant recouvertes par des espaceurs (68) en le deuxième matériau diélectrique.

3. Dispositif selon la revendication 2, dans lequel les structures d'isolation (16) du circuit mémoire et les structures d'isolation (78) du circuit logique ont la même profondeur.

4. Dispositif selon la revendication 2, dans lequel les structures d'isolation (16) du circuit mémoire et les structures d'isolation (78) du circuit logique ont des profondeurs différentes.

5. Dispositif selon l'une quelconque des revendications 1 à 4, dans lequel chaque cellule mémoire comprend un élément mémoire (M) comportant une couche (47) en un matériau à changement de phase.

6. Dispositif selon l'une quelconque des revendications 1 à 5, dans lequel le circuit mémoire comporte un empilement d'interconnexion (35) disposé sur le substrat semiconducteur (13), comportant une succession de niveaux (36) dans lequel sont définis des éléments d'interconnexion (63, 69, 71).

7. Dispositif selon la revendication 6 dans son rattachement à la revendication 5, dans lequel les éléments mémoires (M) sont disposés au dessus de l'empilement d'interconnexion (35).

8. Procédé de fabrication, dans et sur un substrat semiconducteur (13), d'un dispositif électronique comportant un circuit mémoire comprenant une pluralité de cellules mémoires comprenant chacune un transistor bipolaire de sélection (12) formé dans et sur le substrat semiconducteur, chaque transistor bipolaire de sélection comportant, une région de base (29, 15), une région d'émetteur (27) et une région de collecteur (17), le procédé comportant les étapes de :
- formation de grilles sacrificielles (67) en un matériau sacrificiel sur le substrat semiconducteur (13) ;
- formation d'espaceurs (21) en un matériau diélectrique sur les faces latérales des grilles sacrificielles ;
- retrait du matériau sacrificiel dans les grilles sacrificielles et gravure du substrat en vis-à-vis des grilles sacrificielles de façon à former des ouvertures entourées dans une partie supérieure par les espaceurs et s'étendant dans une partie inférieure dans le substrat et remplissage des ouvertures avec un autre matériau diélectrique de manière à former des structures d'isolation (16) en l'autre matériau diélectrique ; et
- formation d'une couche isolante (18) sur et en contact avec le substrat semiconducteur (13), les structures d'isolation comportant ainsi une partie supérieure (16s) s'étendant verticalement dans la couche isolante (18) et une partie inférieure (16i) s'étendant verticalement dans le substrat semiconducteur (13) entre la région de base (29) et la région d'émetteur (27) des transistors bipolaires, les faces latérales de la partie supérieure (16s) de chaque structure d'isolation (16) étant recouvertes par les espaceurs (21).

9. Procédé selon la revendication 8, dans lequel le dispositif comporte en outre un circuit logique, le circuit logique comportant une pluralité de transistors à effet de champs à ailettes comportant chacun une région de source (70, 72) et une région de drain (70, 72), le procédé comportant les étapes de :
- formation des grilles sacrificielles (67) en un matériau sacrificiel sur le substrat semiconducteur (13) ;
- formation d'espaceurs (68) en le matériau diélectrique sur les faces latérales des grilles sacrificielles ;
- retrait du matériau sacrificiel dans les grilles sacrificielles et gravure du substrat en vis-à-vis des grilles sacrificielles de façon à former des ouvertures entourées dans une partie supérieure par les espaceurs et s'étendant dans une partie inférieure dans le substrat et remplissage des ouvertures avec l'autre matériau diélectrique de manière à former des autres structures d'isolation (78) en l'autre matériau diélectrique ; et
- formation de la couche isolante (18) sur et en contact avec le substrat semiconducteur (13), les autres structures d'isolation comportant ainsi une partie supérieure (78s) s'étendant verticalement dans la couche isolante (18) et une partie inférieure (78i) s'étendant verticalement dans le substrat semiconducteur (13) entre la région de source (70, 72) et la région de drain de chaque transistor à effet de champs à ailettes, les faces latérales de la partie supérieure (78s) de l'autre structure d'isolation (78) étant recouvertes par les espaceurs (68).

10. Procédé selon la revendication 9, dans lequel les étapes de formation des structures d'isolation (16) du circuit mémoire et les autres structures d'isolation (78) du circuit logique sont communes.
